# EUROPÄISCHE PATENTSCHRIFT

(11) **EP 2 176 582 B1**
(45) Veröffentlichungstag und Bekanntmachung des Hinweises auf die Patenterteilung: **03.10.2012**
(21) Anmeldenummer: 08786758.6
(22) Anmeldetag: 01.08.2008
(51) Int. Cl.: F21K 99/00

(54) **STRAHLUNGSEMITTIERENDE VORRICHTUNG**
RADIATION-EMITTING DEVICE
DISPOSITIF ÉMETTEUR DE RAYONNEMENT

(30) Priorität: 10.08.2007 DE 102007037875
(43) Veröffentlichungstag der Anmeldung: 21.04.2010
(73) Patentinhaber: OSRAM AG, 81543 München (DE)
(72) Erfinder: BERBEN, Dirk, 86399 Bobingen (DE)
(86) Internationale Anmeldenummer: PCT/EP2008/060138
(87) Internationale Veröffentlichungsnummer: WO 2009/021859

(56) Entgegenhaltungen:
- EP-A- 0 334 136
- WO-A-2004/100226
- WO-A-2006/133214
- WO-A-2007/141688
- JP-A- 2004 341 105
- US-A1- 2004 208 008
- US-B1- 6 259 103

## Beschreibung

### Technisches Gebiet

Die vorliegende Erfindung betrifft eine Beleuchtungsvorrichtung mit einem strahlungsemittierenden Bauelement nach dem Oberbegriff des Anspruchs 1.

### Stand der Technik

Die Verwendung von lichtemittierenden Dioden (LED) für die Allgemeinbeleuchtung ist durch die als unnatürlich empfundene Farbtemperatur des LED-Lichts erschwert. Die Einstellung einer gewünschten Intensität, Farbe oder Farbtemperatur ("Wohlfühl"-Farbtemperatur) ist bei der Verwendung von LED-Lampen nur sehr eingeschränkt und durch aufwändige und damit teure Lichtmischung unter Zuhilfenahme verschiedener LEDs möglich. Das Ausgabelicht einer LED-Lampe wird dabei aus der Emission verschiedener LEDs zusammengemischt. Da dabei einzelne LEDs gegebenenfalls jedoch nicht mit voller Leistung laufen können, leidet je nach Farbe oder Farbtemperatur die erreichbare Helligkeit beträchtlich. Die Lampe läuft im ungünstigsten Fall nur mit halber Leistung. Weiterhin erschwert eine unterschiedliche Alterung verschiedener LED-Typen eine einfache elektronische Regelung der abgestrahlten Farbtemperatur.

Aus der WO 200/133214 ist eine Beleuchtungtungsvorrichtung mit einem rotierenden Rad bekannt, das mit verschiedenen Leuchtstoffen zurErzeugung verschiedener Farben beschichtet ist.

Beispielsweise gibt es Ansätze mit Reglern, welche in die elektrische Versorgung einzelner LEDs in einer LED-Lampe eingreifen, um die Farbtemperatur zu verändern. Hierzu werden etwa kaltweiße und warmweiße LEDs nebeneinander betrieben und je nach gewünschter Farbtemperatur gedimmt. Alternativ dazu wird eine mittelwarmweiße LED verwendet, welche von verschiedenen roten, grünen und blauen LEDs unterstützt wird. In beiden Fällen ist eine aufwändige Regelung notwendig und je nach Einstellung laufen nicht alle LEDs mit Nennleistung. Die Lampe bleibt somit in ihrer Ausgabeleistung hinter ihren Möglichkeiten zurück.

### Darstellung der Erfindung

Zumindest eine Aufgabe von bestimmten Ausführungsformen ist es, eine strahlungsemittierende Vorrichtung, die eine elektromagnetische Sekundärstrahlung emittiert, mit einem strahlungsemittierenden Bauelement anzugeben.

Diese Aufgabe wird durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Eine strahlungsemittierende Vorrichtung gemäß einer Ausführungsform umfasst insbesondere
- zumindest ein strahlungsemittierendes Bauelement, das im Betrieb elektromagnetische Primärstrahlung auf einen im Strahlengang des strahlungsemittierenden Bauelements angeordneten Träger mit einem ersten und einem zweiten Teilbereich emittiert und
- einen im ersten Teilbereich angeordneten ersten Wellenlängenkonversionsstoff zur zumindest teilweisen Konversion der Primärstrahlung,
wobei
- der erste und zweite Teilbereich voneinander verschieden sind,
- die von der strahlungsemittierenden Vorrichtung abgestrahlte Sekundärstrahlung die von dem ersten und/oder zweiten Teilbereich abgestrahlte elektromagnetische Strahlung umfasst und
- die Sekundärstrahlung durch eine Änderung der Ausrichtung des strahlungsemittierenden Bauelements relativ zum Träger veränderbar ist.

Die strahlungsemittierende Vorrichtung kann somit die Einstellung und Anpassung der abgestrahlten Sekundärstrahlung, beispielsweise deren Intensität, Farbtemperatur und/oder Farbort, durch eine relative Änderung des strahlungsemittierenden Bauelements zum Träger ermöglichen. Dabei kann es möglich sein, dass das strahlungsemittierende Bauelement durchgehend in einen unveränderten Betriebszustand betrieben werden kann und eine unveränderte Primärstrahlung abstrahlen kann, während die von der strahlungsemittierenden Vorrichtung abgestrahlte Sekundärstrahlung dennoch veränderbar ist. Ein unveränderter Betriebszustand des strahlungsemittierenden Bauelements kann dabei bedeuten, dass die Primärstrahlung unverändert hinsichtlich ihrer Intensität und/oder ihres Spektralbereichs beibehalten wird. Dadurch kann es möglich sein, dass eine wie oben beschriebene aufwändige Regelung der elektrischen Versorgung des strahlungsemittierenden Bauelements zur Regelung der Sekundärstrahlung verringert werden oder ganz entfallen kann. Es kann dabei weiterhin möglich sein, dass die Änderbarkeit der Sekundärstrahlung keinen Einfluss auf den Betriebszustand des strahlungsemittierenden Bauelements, also beispielsweise auf die Temperatur oder die elektrischen Parameter, hat.

Die Sekundärstrahlung kann dabei derart veränderbar sein, dass zumindest einer der Parameter Intensität, Farbe, also Farbort, und Farbtemperatur der Sekundärstrahlung veränderbar sein kann.

Das strahlungsemittierende Bauelement kann einen ersten Anteil der Primärstrahlung auf den ersten Teilbereich des Trägers und einen zweiten Anteil der Primärstrahlung auf den zweiten Teilbereich des Trägers strahlen. Der erste Anteil und der zweite Anteil können dabei jeweils durch eine erste und zweite Intensität und/oder durch einen ersten und zweiten Raumwinkelbereich, in den der erste bzw. zweite Anteil abgestrahlt wird, charakterisiert werden. Zumindest einer der beiden Anteile, also der erste Anteil oder der zweite Anteil oder beide Anteile, kann durch die Änderung der relativen Ausrichtung von strahlungsemittierenden-Bauelement und Träger zueinander veränderbar sein. Das kann bedeuten, dass der erste Anteil der Primärstrahlung, der auf den ersten Teilbereich gestrahlt wird, und/oder der zweite Anteil der Primärstrahlung, der auf den zweiten Teilbereich gestrahlt wird, durch die besagte relative Änderung veränderbar sind. Da somit die vom ersten Teilbereich und/oder vom zweiten Teilbereich abgestrahlte elektromagnetische Strahlung veränderbar ist, kann dadurch eine Änderung der elektromagnetischen Sekundärstrahlung ermöglicht werden.

Der erste Anteil und der zweite Anteil der Primärstrahlung können dabei durch die Änderung der Ausrichtung des strahlungsemittierenden Bauelements relativ zum Träger zueinander entgegengesetzt veränderbar sein. "Entgegengesetzt" kann dabei bedeuten, dass der erste Anteil beispielsweise durch eine erste Änderung der relativen Ausrichtung des strahlungsemittierenden Bauelements zum Träger erhöht werden kann während der zweite Anteil gleichzeitig erniedrigt werden kann, wobei die Summe aus dem ersten Anteil und dem zweiten Anteil hinsichtlich Intensität oder Raumwinkelbereich gleich bleiben kann. Durch eine zweite Änderung der Ausrichtung des strahlungsemittierenden Bauelements relativ zum Träger, die der ersten Änderung entgegengesetzt sein kann, kann eine umgekehrte Änderung des ersten und zweiten Anteils jeweils möglich sein.

Dabei kann einer des ersten und des zweiten Anteils in einer bestimmten Ausrichtung des strahlungsemittierenden Bauelements relativ zum Träger null sein, während der andere Anteil maximal sein kann. Beispielsweise kann die elektromagnetische Primärstrahlung lediglich auf den ersten Teilbereich in einer relativen Ausrichtung des strahlungsemittierenden Bauelements zum Träger eingestrahlt werden. In diesem Fall ist die elektromagnetische Sekundärstrahlung die von der strahlungsemittierenden Vorrichtung emittiert werden kann, durch die elektromagnetische Strahlung gegeben, die vom ersten Teilbereich abgestrahlt wird. Die elektromagnetische Strahlung, die vom ersten Teilbereich abgestrahlt wird, kann reflektierte Primärstrahlung und/oder durch den Wellenlängenkonversionsstoff durch Konversion von Primärstrahlung erzeugte Strahlung umfassen. Da der erste Teilbereich eben den Wellenlängenkonversionsstoff umfasst, kann die elektromagnetische Sekundärstrahlung somit verschieden von der elektromagnetischen Primärstrahlung sein. Durch eine Änderung der Position des strahlungsemittierenden Bauelements relativ zum Träger kann der erste Anteil der elektromagnetischen Primärstrahlung, also der Anteil der elektromagnetischen Primärstrahlung der auf den ersten Teilbereich des Trägers fällt, verringert werden und gleichzeitig der zweite Anteil der elektromagnetischen Strahlung, also der Anteil der Primärstrahlung, der auf den zweiten Teilbereich des Trägers fällt, erhöht werden. Entspricht der zweite Anteil der Primärstrahlung der gesamten Intensität der Primärstrahlung, so ist die elektromagnetische Sekundärstrahlung, die von der strahlungsemittierten Vorrichtung abgestrahlt wird, allein durch die elektromagnetische Strahlung die vom zweiten Teilbereich abgestrahlt wird gegeben.

Beispielsweise kann die Änderung der Sekundärstrahlung durch eine mechanische Änderung der relativen Ausrichtung des strahlungsemittierenden Bauelements zum Träger ermöglicht werden. Somit kann eine Einstellung und/oder Änderung der Sekundärstrahlung mit mechanischen Mitteln möglich sein. Durch die Änderung der relativen Ausrichtung des strahlungsemittierenden Bauelements zum Träger kann somit eine Änderung des Strahlengangs der Primärstrahlung relativ zum Träger möglich sein. Zur mechanischen Änderung der relativen Ausrichtung des strahlungsemittierenden Bauelements zum Träger kann die strahlungsemittierende Vorrichtung eine mechanische Vorrichtung umfassen, die veränderbar die relative Position des strahlungsemittierenden Bauelements zum Träger fixieren kann. Die mechanische Vorrichtung kann dabei beispielsweise einen Schiebe- und/oder Drehmechanismus umfassen, der etwa eine Schiene, einen Gleiter, ein Gelenk, ein Scharnier und/oder eine Drehachse aufweisen kann.

Beispielsweise kann die Sekundärstrahlung durch eine Translation des strahlungsemittierenden Bauelements relativ zum Träger änderbar sein. Das kann bedeuten, dass beispielsweise das strahlungsemittierende Bauelement relativ zum Träger, der wiederum starr gelagert oder befestigt sein kann, verschiebbar sein kann. Alternativ oder zusätzlich kann auch der Träger relativ zum strahlungsemittierenden Bauelement verschiebbar sein. Die Translation kann dabei beispielsweise entlang einer geraden oder entlang einer gekrümmten Linie erfolgen. Beispielsweise kann die Translation auf einem kreisförmigen oder elliptischen Translationsweg erfolgen.

Eine Translation kann eine kontinuierliche Verschiebung oder eine Verschiebung in diskreten Schritten, beispielsweise vorgegeben durch eine Rasterung, umfassen oder sein.

Beispielsweise können der erste und der zweite Teilbereich entlang einer Anordnungsrichtung angeordnet sein und das strahlungsemittierende Bauelement kann entlang oder parallel zu dieser Anordnungsrichtung relativ zum Träger verschiebbar sein. Die Anordnungsrichtung kann dabei einer geraden oder einer gekrümmten Linie entsprechen.

Der erste und/oder zweite Teilbereich kann dabei eine der folgenden Formen oder eine Kombination daraus aufweisen: Dreieck, Quadrat, Rechteck, n-Eck mit n größer als 4, regelmäßiges oder unregelmäßiges Polygon, Kreis, Ellipse, Segment oder Sektor eines Kreises oder einer Ellipse. Abhängig von der Form des Trägers wie weiter unten ausgeführt kann die Form des ersten und/oder zweiten Teilbereichs in einer Euklidischen oder nicht-Euklidischen Geometrie ausgebildet sein.

Der erste Bereich und der zweite Bereich des Trägers können dabei direkt aneinander angrenzen, also beispielsweise eine oder mehrere aneinander angrenzende Bereiche aufweisen.

Weiterhin kann die Sekundärstrahlung durch eine Rotation des strahlungsemittierenden Bauelements relativ zum Träger änderbar sein. Das kann bedeuten, dass das strahlungsemittierende Bauelement drehbar gelagert ist und der Träger relativ zur Umgebung starr und unbeweglich gelagert ist. Alternativ oder auch zusätzlich kann der Träger drehbar gelagert sein. Beispielsweise können wie oben beschrieben der erste und der zweite Teilbereich entlang einer Anordnungsrichtung angeordnet sein. Das strahlungsemittierende Bauelement kann dann relativ zum Träger um eine Drehachse drehbar sein, die zumindest nicht parallel zu dieser Anordnungsrichtung ist. Besonders bevorzugt kann die Drehachse senkrecht zur Anordnungsrichtung sein, so dass die Primärstrahlung entlang und/oder parallel zur Anordnungsrichtung über den ersten und zweiten Teilbereich schwenkbar sein kann.

Eine Rotation kann eine kontinuierliche Drehung oder eine Drehung um diskrete Winkel, beispielsweise vorgegeben durch eine Rasterung, umfassen oder sein.

Weiterhin kann das strahlungsemittierende Bauelement ein strahlungslenkendes Bauelement aufweisen, das im Strahlengang der Primärstrahlung angeordnet ist. Die Änderung der Ausrichtung des strahlungsemittierenden Bauelements relativ zum Träger kann dabei auch eine Änderung des strahlungslenkenden Bauelements relativ zum Träger umfassen oder sein. Alternativ oder zusätzlich zu einer Relativbewegung des gesamten strahlungsemittierenden Bauelements zum Träger, also eine Änderung der räumlichen Position des strahlungsemittierenden Bauelements bei einem starr gelagerten Träger oder umgekehrt, kann die von der strahlungsemittierenden Vorrichtung abgestrahlte Sekundärstrahlung durch ein Verschieben und/oder durch eine Drehung des strahlungslenkenden Bauelements relativ zum Träger änderbar sein. Durch das strahlungslenkende Bauelement kann der Strahlengang der elektromagnetischen Primärstrahlung des strahlungsemittierenden Bauelements änderbar sein. Die Verschiebung und/oder die Drehung des strahlungslenkenden Bauelements kann relativ zum ersten und zweiten Teilbereich wie oben für das strahlungsemittierende Bauelement als ganzes beschrieben auch für das strahlungslenkende Bauelement möglich sein. Dabei kann das strahlungslenkende Bauelement einen Spiegel, ein Prisma, ein Lichtleiter, eine Linse oder eine Kombination daraus umfassen oder sein.

Weiterhin kann der Träger eine gekrümmte Form aufweisen. Beispielsweise kann der Träger als Teil einer Zylinderoberfläche bzw. einer Hohlzylinderinnenfläche ausgebildet sein. Der dabei zugrunde liegende Zylinder kann dabei eine kreisförmige, elliptische, parabolische oder mehreckige Grundlinie oder Grundfläche oder eine Kombination daraus aufweisen. Weiterhin kann der Träger auch als Teil eines Rotationsellipsoiden oder eines Rotationsparaboloiden ausgebildet sein. Der erste und zweite Teilbereich des Trägers können dabei auf der Innen- oder Außenseite, also auf einer konvex oder konkav geformten Oberfläche der oben genannten Formen angeordnet sein.

Alternativ oder zusätzlich kann der Träger eine ebene, flache Form umfassen. Der Träger kann weiterhin einen Kunststoff, ein Metall, eine Keramik oder Kombinationen daraus aufweisen oder aus einem der genannten Materialien sein.

Die strahlungsemittierende Vorrichtung kann weiterhin eine Mehrzahl von strahlungsemittierenden Bauelementen aufweisen. Der erste und/oder zweite Bereich kann dabei im Strahlengang der Mehrzahl von strahlungsemittierenden Bauelementen angeordnet sein. Dabei kann die strahlungsemittierende Vorrichtung auf dem Träger auch eine Mehrzahl von ersten und zweiten Bereichen aufweisen. In diesem Fall kann insbesondere jeweils einem ersten und einem zweiten Teilbereich ein strahlungsemittierendes Bauelement zugeordnet sein, so dass jeweils ein erster und ein zweiter Teilbereich des Trägers im Strahlengang eines strahlungsemittierenden Bauelements angeordnet sein kann.

Die relative Anordnung eines jeden der Mehrzahl von strahlungsemittierenden Bauelementen zu den jeweils zugeordneten ersten und zweiten Teilbereichen kann dabei für alle strahlungsemittierende Bauelemente in gleicher Weise, also simultan, erfolgen. Alternativ oder zusätzlich dazu kann es auch möglich sein, dass zumindest ein erstes der Mehrzahl der strahlungsemittierenden Bauelemente unabhängig von zumindest einem zweiten der Mehrzahl von strahlungsemittierenden Bauelementen in seiner Ausrichtung relativ zum Träger veränderbar ist. Dabei können das erste und das zweite der Mehrzahl von strahlungsemittierenden Bauelementen dieselbe oder voneinander verschiedene der oben genannten Bewegungsmöglichkeiten relativ zum Träger aufweisen.

Der Wellenlängenkonversionsstoff kann einen oder mehrere der folgenden Materialien aufweisen: Granate der Seltenen Erden und der Erdalkalimetalle, beispielsweise YAG:Ce³⁺, Nitride, Nitridosilikate, Sione, Sialone, Aluminate, Oxide, Halophosphate, Orthosilikate, Sulfide, Vanadate, Perylene, Coumarin und Chlorosilikate. Weiterhin kann der Wellenlängenkonversionsstoff auch geeignete Mischungen und/oder Kombinationen daraus umfassen.

Der Wellenlängenkonversionsstoff kann dabei direkt auf dem Träger aufgebracht sein. Der Wellenlängenkonversionsstoff und/oder das Matrixmaterial kann beispielsweise durch ein Sprüh- oder Druckverfahren, mittels Dip-Coating, Rakeln, Aufpinseln oder mittels eines elektrophoretischen Verfahrens auf dem Träger aufbringbar sein.

Weiterhin kann der Wellenlängenkonversionsstoff in einem transparenten Matrixmaterial eingebettet sein, das den Wellenlängenkonversionsstoff umgibt oder enthält oder das an den Wellenlängenkonversionsstoff chemisch gebunden ist. Das transparente Matrixmaterial kann beispielsweise Silikone, Epoxide, Acrylate, Imide, Carbonate, Olefine oder Derivate davon in Form von Monomeren, Oligomeren oder Polymeren als Mischungen, Copolymere oder Verbindungen damit aufweisen. Beispielsweise kann das Matrixmaterial ein Epoxidharz, Polymethylmethacrylat (PMMA) oder ein Silikonharz sein.

Der Wellenlängenkonversionsstoff kann dabei homogen im Matrixmaterial verteilt sein. Alternativ können verschiedene Wellenlängenkonversionsstoffe in verschiedenen Schichten oder Bereichen des Matrixmaterials verteilt und angeordnet sein.

Weiterhin kann der zweite Teilbereich einen zweiten Wellenlängenkonversionsstoff aufweisen, der verschieden vom ersten Wellenlängenkonversionsstoff im ersten Teilbereich ist. Der zweite Wellenlängenkonversionsstoff kann dadurch geeignet sein, die elektromagnetische Primärstrahlung zumindest teilweise in elektromagnetische Strahlung umzuwandeln, die von der Primärstrahlung verschieden ist und die andere Wellenlängen oder Wellenlängenbereiche als die elektromagnetische Strahlung aufweist, die vom ersten Wellenlängenkonversionsstoff durch Konversion erzeugt wird.

Weiterhin kann der Träger im ersten Teilbereich und/oder im zweiten Teilbereich eine für die Primärstrahlung reflektierende Oberfläche aufweisen. Insbesondere kann die reflektierende Oberfläche beispielsweise im ersten Teilbereich dem ersten Wellenlängenkonversionsstoff im Strahlengang der Primärstrahlung nachgeordnet angeordnet sein. Dabei kann etwa der erste Wellenlängenkonversionsstoff auf der reflektierenden Oberfläche des Trägers im ersten Teilbereich aufgetragen sein. Weist auch der zweite Teilbereich einen zweiten Wellenlängenkonversionsstoff auf, so kann für diesen dasselbe gelten. Durch die reflektierende Oberfläche kann unkonvertierte Primärstrahlung, die den ersten Wellenlängenkonversionsstoff im ersten Teilbereich beispielsweise durchquert hat, in den ersten Wellenlängenkonversionsstoff zurückreflektiert werden, so dass die Konversionswahrscheinlichkeit dadurch effektiv erhöht werden kann. Weist beispielsweise der zweite Teilbereich keinen zweiten Wellenlängenkonversionsstoff auf, so kann durch die reflektierende Oberfläche eine Reflexion der elektromagnetischen Primärstrahlung vom Träger weg ermöglicht werden.

Insbesondere kann die reflektierende Oberfläche diffus reflektierend sein. Das kann bedeuten, dass die elektromagnetische Primärstrahlung, die gerichtet auf den Träger eingestrahlt werden kann, isotrop, also gleichmäßig in verschiedene Richtungen vom Träger reflektiert werden kann. Dazu kann die reflektierende Oberfläche beispielsweise aufgeraut sein oder eine reflektierende Mikrostruktur aufweisen.

Weiterhin kann der erste Teilbereich und/oder der zweite Teilbereich Streupartikel aufweisen. Die Streupartikel können dabei auf der Oberfläche des Trägers im ersten Teilbereich und/oder im zweiten Teilbereich angeordnet sein, oder sie können zusammen mit dem ersten beziehungsweise zweiten Wellenlängenkonversionsstoff wie oben beschrieben in einem Matrixmaterial eingeschlossen und auf dem ersten beziehungsweise zweiten Teilbereich aufgebracht sein. Insbesondere können die Streupartikel beispielsweise ein Metalloxid, so etwa Titanoxid oder Aluminiumoxid wie etwa Korund, und/oder Glaspartikel umfassen. Die Streupartikel können dabei Durchmesser oder Korngrößen von weniger als einem Mikrometer bis zu einer Größenordnung von 10 Mikrometer aufweisen.

Darüber hinaus kann der Träger im ersten Teilbereich und/oder im zweiten Teilbereich eine für die Primärstrahlung absorbierende Oberfläche aufweisen. Das kann bedeuten, dass Primärstrahlung, die auf die absorbierende Oberfläche eingestrahlt wird, nicht mehr vom Träger reflektiert werden kann. Beispielsweise kann dadurch eine Regelung der Helligkeit der von der strahlungsemittierenden Vorrichtung emittierten elektromagnetischen Sekundärstrahlung durch die Änderung der Ausrichtung des strahlungsemittierenden Bauelements relativ zum Träger ermöglicht werden.

Weiterhin kann beispielsweise mittels zumindest einer der oben beschriebenen Ausführungsformen der Farbort der Sekundärstrahlung durch die relative Änderung der Ausrichtung von strahlungsemittierenden Bauelement und Träger zueinander einstellbar sein, während die Intensität der Sekundärstrahlung unabhängig vom Farbort mittels Änderung des Betriebszustandes des strahlungsemittierenden Bauelements vorgenommen werden kann.

Zusätzlich kann der Träger weiterhin zum ersten und zum zweiten Teilbereich zumindest einen dritten Teilbereich aufweisen, der vom ersten und vom zweiten Teilbereich verschieden ist. Das kann bedeuten, dass die vom dritten Teilbereich abgestrahlte elektromagnetische Strahlung verschieden von der vom ersten und zweiten Teilbereich jeweils abgestrahlten elektromagnetischen Strahlung ist. Durch die oben beschriebene Änderung der Ausrichtung des strahlungsemittierenden Bauelements relativ zum Träger in Form von Translations- und/oder Rotationsbewegungen, insbesondere durch zwei voneinander unabhängige Translations- und/oder Rotationsbewegungen kann die Änderung der Sekundärstrahlung um einen Freiheitsgrad erweitert werden. Damit kann es möglich sein, dass die oben beschriebene Änderungsmöglichkeit zwischen zwei begrenzenden Farborts- und/oder Helligkeitseinstellungen entsprechend der vom ersten und zweiten Teilbereich abgestrahlten elektromagnetischen Strahlung auf eine Änderung zwischen drei begrenzenden Farborts- und/oder Helligkeitseinstellungen erweitert werden kann.

Das strahlungsemittierende Bauelement kann eine Halbleiter-Leuchtdiode (LED) umfassen oder ist eine LED. Die LED kann dabei bevorzugt ein- oder mischfarbige Strahlung aussenden. Die LED kann beispielsweise eine Halbleiterschichtenfolge mit einem oder mehreren aktiven Bereichen aufweisen, die im Betrieb, insbesondere bei Aufprägung eines Stroms, elektromagnetische Strahlung erzeugt.

Die Halbleiterschichtenfolge kann als Epitaxieschichtenfolge, also als epitaktisch gewachsene Halbleiterschichtenfolge, ausgeführt sein. Dabei kann die Halbleiterschichtenfolge beispielsweise auf der Basis eines anorganischen Materials, etwa von InGaAlN, wie etwa GaN-Dünnfilm-Halbleiterchips, ausgeführt sein. Unter InGaAlN-basierte Halbleiterchips fallen insbesondere solche, bei denen die epitaktisch hergestellte Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x+y ≤ 1 aufweist. Alternativ oder zusätzlich kann die Halbleiterschichtenfolge auch auf InGaA1P basieren, das heißt, dass die Halbleiterschichtenfolge unterschiedliche Einzelschichten aufweist, wovon mindestens eine Einzelschicht ein Material aus dem III-V-Verbindungshalbleitermaterialsystem InₓAl_{y}Ga_{1-x-y}P mit 0 ≤ x ≤ 1, 0 ≤ y ≤ 1 und x+y ≤ 1 aufweist. Alternativ oder zusätzlich kann die Halbleiterschichtenfolge auch andere III-V-Verbindungshalbleitermaterialsysteme, beispielsweise ein AlGaAs-basiertes Material, oder II-VI-Verbindungshalbleitermaterialsysteme aufweisen.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Die Halbleiterschichtenfolge kann neben dem aktiven Bereich weitere funktionale Schichten und funktionelle Bereiche umfassen, etwa p- oder n-dotierte Ladungsträgertransportschichten, also Elektronen- oder Löchertransportschichten, p- oder n-dotierte Confinement- oder Cladding-Schichten, Barriereschichten, Planarisierungsschichten, Pufferschichten, Schutzschichten und/oder Elektroden sowie Kombinationen daraus. Solche Strukturen den aktiven Bereich oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Die elektromagnetische Primärstrahlung kann dabei eine Wellenlänge oder einen Wellenlängenbereich aus einem ultravioletten bis infraroten Spektralbereich umfassen. Beispielsweise kann das strahlungsemittierende Bauelement elektromagnetische Primärstrahlung im ultravioletten Spektralbereich und/oder im blauen Spektralbereich abstrahlen. Die Primärstrahlung kann dabei eine oder mehrere Wellenlängen im Bereich von etwa 365 nm bis etwa 490 nm umfassen.

Die elektromagnetische Sekundärstrahlung kann zumindest teilweise von der elektromagnetischen Primärstrahlung verschieden sein. Das kann bedeuten, dass die elektromagnetische Sekundärstrahlung Wellenlängen oder Wellenlängenbereiche aufweist, die nicht im elektromagnetischen Spektrum der Primärstrahlung enthalten sind. Diese Wellenlängen oder Wellenlängenbereiche können beispielsweise durch den Wellenlängenkonversionsstoff im ersten Teilbereich erzeugt werden, der zumindest einen Teil der elektromagnetischen Primärstrahlung in elektromagnetische Strahlung mit von der elektromagnetischen Primärstrahlung unterschiedlichen Wellenlängen oder Wellenlängenbereich konvertieren kann. Beispielsweise kann die Sekundärstrahlung Wellenlängen im Bereich von etwa 530 nm bis etwa 650 nm umfassen, also Wellenlängen aus einem grünen bis roten Spektralbereich.

Beispielsweise kann die vom ersten Teilbereich abgestrahlte elektromagnetische Strahlung einen warmweißen Leuchteindruck bei einem externen Beobachter erwecken. Das kann bedeuten, dass der erste Teilbereich einen ersten Wellenlängenkonversionsstoff aufweist, der die Primärstrahlung, die beispielsweise einen ultravioletten bis blauen Spektralbereich umfasst, zumindest teilweise in elektromagnetische Strahlung im gelben und/oder grünen und roten Spektralbereich umwandeln kann. Ein Teil der Primärstrahlung kann vom ersten Teilbereich reflektiert werden, so dass die Überlagerung der umgewandelten elektromagnetischen Strahlung mit dem reflektierten Teil der Primärstrahlung als warmweiße Sekundärstrahlung wahrnehmbar ist. Alternativ dazu kann die Primärstrahlung im ultravioletten Spektralbereich liegen, wobei der Wellenlängenkonversionsstoff die ultraviolette Primärstrahlung in elektromagnetische Strahlung umwandeln kann, die eine Mischung aus mehreren Wellenlängen, etwa im blauen, grünen, gelben und/oder roten Spektralbereich, aufweist und die von der strahlungsemittierenden Vorrichtung als warmweiße Sekundärstrahlung abgestrahlt werden kann.

Weiterhin kann die vom zweiten Teilbereich abgestrahlte elektromagnetische Strahlung einen kaltweißen Leuchteindruck erwecken, wobei wie vorab für den ersten Teilbereich beschrieben die Primärstrahlung im ultravioletten oder im ultravioletten bis blauen Spektralbereich liegen kann. Der zweite Teilbereich kann dann entsprechend einen vom ersten Wellenlängenkonversionsstoff im ersten Teilbereich verschiedenen zweiten Wellenlängenkonversionsstoff aufweisen, der zumindest einen Teil der Primärstrahlung in elektromagnetische Strahlung umwandeln kann, dass die strahlungsemittierende Vorrichtung kaltweiße Sekundärstrahlung abstrahlen kann.

Durch die oben beschriebene Änderung der relativen Ausrichtung des strahlungsemittierenden Bauelements und der Trägers zueinander kann somit die Farbtemperatur der von der strahlungsemittierenden Vorrichtung abgestrahlten Sekundärstrahlung auf einfache Weise zwischen einem kaltweißen und einem warmweißen Leuchteindruck verändert werden.

### Kurze Beschreibung der Zeichnungen

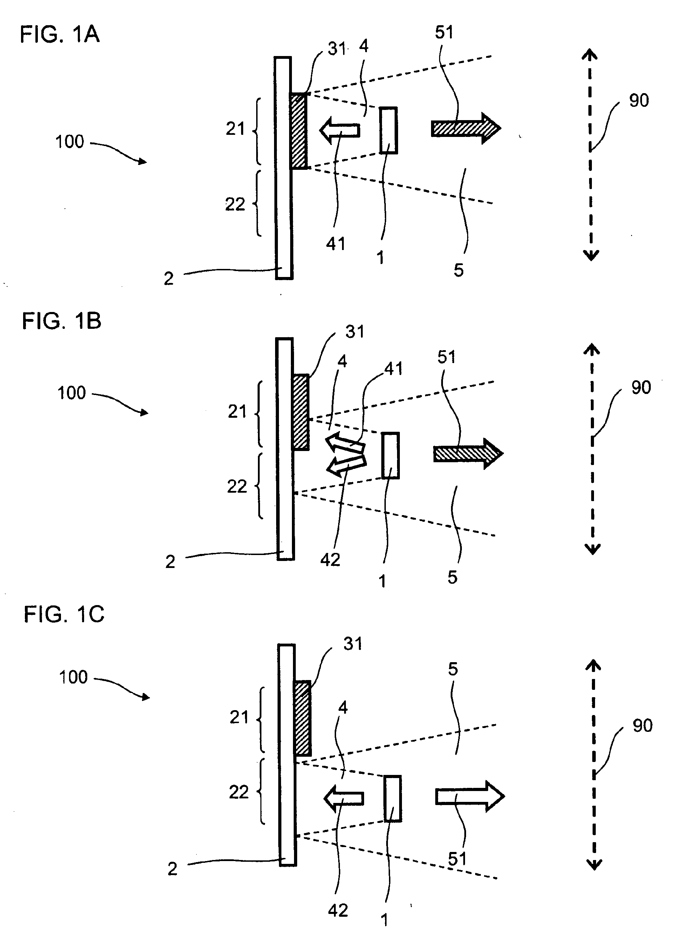

Im Folgenden soll die Erfindung anhand von Ausführungsbeispielen näher erläutert werden. Weitere Vorteile und vorteilhafte Ausführungsformen und Weiterbildungen der Erfindung ergeben sich aus den im Folgenden in Verbindung mit den Figuren 1A bis 6 beschriebenen Ausführungsformen. Die Figuren zeigen:
Figuren 1A bis 1C schematische Darstellungen einer strahlungsemittierenden Vorrichtung gemäß einem Ausführungsbeispiel,
Figuren 2A bis 6 schematische Darstellungen strahlungsemittierender Vorrichtungen gemäß weiteren Ausführungsbeispielen und
Figur 7 ein CIE-Farbortdiagramm zur Illustration der Änderung der Sekundärstrahlung von strahlungsemittierenden Vorrichtungen gemäß weiterer Ausführungsbeispiele.

### Bevorzugte Ausführung der Erfindung

In den Ausführungsbeispielen und Figuren können gleiche und gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In Figuren 1A bis 1C ist ein Ausführungsbeispiel für eine strahlungsemittierende Vorrichtung 100 gezeigt. Die strahlungsemittierende Vorrichtung 100 weist dabei ein strahlungsemittierendes Bauelement 1 auf, das im Betrieb elektromagnetische Primärstrahlung 4 auf einen im Strahlengang des strahlungsemittierenden Bauelements 1 angeordneten Träger 2 emittiert.

Der Träger 2, der aus einem Kunststoff gefertigt ist, weist einen ersten Teilbereich 21 und einen zweiten Teilbereich 22 auf. Der erste und zweite Teilbereich 21, 22 sind dabei nebeneinander und direkt aneinander angrenzend angeordnet. Dabei weist der erste Teilbereich 21 einen Wellenlängenkonversionsstoff 31 auf, der geeignet ist, einen Teil der Primärstrahlung 4 des strahlungsemittierenden Bauelements 1 zu konvertieren. In Figur 1A ist eine Ausrichtung des strahlungsemittierenden Bauelements 1 relativ zum Träger 2 gezeigt, bei der ein erster Anteil 41 der Primärstrahlung 4 auf den Wellenlängenkonversionsstoff 31 fällt, wobei der erste Anteil 41 in Figur 1A der gesamten vom strahlungsemittierenden Bauelement 1 abgestrahlten Primärstrahlung 4 entspricht. Die Primärstrahlung 4 wird vom Wellenlängenkonversionsstoff 31 zumindest teilweise in von der Primärstrahlung 4 verschiedene elektromagnetische Strahlung konvertiert und vom Wellenlängenkonversionsstoff 31 beziehungsweise vom ersten Teilbereich 21 wieder abgestrahlt. Die vom Träger 2 und damit von der strahlungsemittierenden Vorrichtung 100 abgestrahlte elektromagnetische Sekundärstrahlung 5 entspricht somit der vom ersten Teilbereich 21 des Trägers 2 abgestrahlten elektromagnetischen Strahlung, angedeutet durch den Pfeil 51 in Figur 1A.

Das strahlungsemittierende Bauelement 1 ist entlang der Translationsrichtung 90 relativ zum Träger 2 verschiebbar. Die Translationsrichtung 90 ist dabei parallel zur Anordnungsrichtung des ersten und zweiten Teilbereichs 21, 22 des Trägers 2. Dazu ist der Träger 2 starr an einer Halterung (nicht gezeigt) montiert, während das strahlungsemittierende Bauelement 1 auf einem mechanischen Verschiebemechanismus (nicht gezeigt) gelagert beziehungsweise angeordnet ist. Alternativ oder zusätzlich kann auch der Träger 2 auf einem mechanischen Verschiebemechanismus angeordnet sein.

In Figur 1B ist eine Ausrichtung des strahlungsemittierenden Bauelements 1 relativ zum Träger 2 gezeigt, bei der das strahlungsemittierende Bauelement 1 entlang der Translationsrichtung 90 verschoben wurde. Wie in Figur 1B gezeigt, fällt ein erster Anteil 41 der Primärstrahlung 4 immer noch auf den ersten Teilbereich 21 und damit auf den Wellenlängenkonversionsstoff 31. Ein zweiter Anteil 42 der Primärstrahlung 4 fällt auf den zweiten Teilbereich 22. Die von der strahlungsemittierenden Vorrichtung 100 abgestrahlte Sekundärstrahlung 5 ist damit gegeben durch die elektromagnetische Strahlung, die vom ersten Teilbereich abgestrahlt wird und durch die elektromagnetische Strahlung, die vom zweiten Teilbereich abgestrahlt wird. Da der erste und zweite Teilbereich 21, 22 voneinander verschieden sind, unterscheidet sich auch die elektromagnetische Sekundärstrahlung 5 in der Figur 1B von der in Figur 1A wie durch die unterschiedlichen Schraffierung der Pfeile 51 angedeutet ist.

Figur 1C zeigt den zu Figur 1A entgegen gesetzten Fall, nämlich dass das strahlungsemittierende Bauelement 1 durch eine weitere Verschiebung entlang der Richtung 90 derart relativ zum Träger 2 angeordnet beziehungsweise ausgerichtet ist, dass der zweite Anteil 42 der Primärstrahlung der gesamten Primärstrahlung 4 entspricht, so dass die gesamte Primärstrahlung 4 auf den zweiten Teilbereich 22 abgestrahlt wird. Dadurch ist die elektromagnetische Sekundärstrahlung 5, die von der strahlungsemittierenden Vorrichtung 100 in der Figur 1C emittiert wird, durch die elektromagnetische Strahlung gegeben, die allein vom zweiten Teilbereich 22 abgestrahlt wird. Diese unterscheidet sich von der elektromagnetischen Sekundärstrahlung der Figuren 1A und 1B wie durch den nicht-schraffierten Pfeil 51 angedeutet ist.

Die in den Figuren 1A und 1C gezeigten relativen Ausrichtungen von strahlungsemittierenden Bauelement 1 und Träger 2 stellen die zwei Grenzfälle dar, bei denen die Sekundärstrahlung 5 lediglich durch die vom ersten Teilbereich 21 (Figur 1A) beziehungsweise zweiten Teilbereich 22 (Figur 1C) abgestrahlte elektromagnetische Strahlung gegeben ist. Zwischen diesen beiden Grenzfällen können kontinuierlich oder diskret einstellbare relative Ausrichtungen einstellbar sein, bei denen die Sekundärstrahlung entsprechend dem ersten beziehungsweise zweiten Anteil 41 und 42 der Primärstrahlung 4 durch die Überlagerung der vom ersten und zweiten Teilbereich 21, 22 abgestrahlten elektromagnetischen Strahlung gegeben ist. Die in Figur 1B gezeigte relative Ausrichtung zeigt dabei lediglich eine dafür beispielhafte relative Ausrichtung.

Alternativ zu den in den Figuren 1A und 1C gezeigten Grenzfällen, in denen die gesamte Primärstrahlung auf den ersten beziehungsweise zweiten Teilbereich 21, 22 fällt, sind auch Grenzfälle möglich, bei denen wie in Figur 1B gezeigt ein erster Anteil 41 auf den ersten Teilbereich 21 und eine zweiter Anteil 42 auf den zweiten Teilbereich 22 fällt.

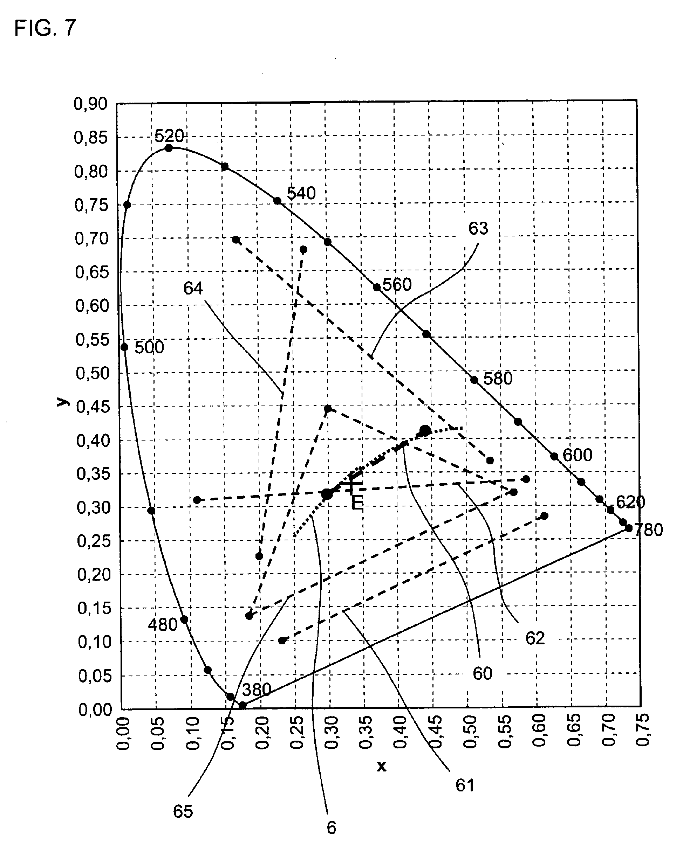

In einer Ausgestaltung des Ausführungsbeispiels in den Figuren 1A bis 1C umfasst das strahlungsemittierende Bauelement 1 eine LED, die blaufarbige Primärstrahlung abstrahlt. Der Wellenlängenkonversionsstoff 31 ist derart gewählt, dass nahezu die gesamte auf den ersten Teilbereich 21 fallende blaue Primärstrahlung 4 in rote elektromagnetische Strahlung umgewandelt und vom Träger 2 abgestrahlt wird. Im zweiten Teilbereich 22 weist der Träger 2 eine diffus reflektierende Oberfläche auf, die die blaue Primärstrahlung 4 reflektieren kann. In den in den Figuren 1A und 1C gezeigten Grenzfällen strahlt der Träger 2 und damit die strahlungsemittierende Vorrichtung 100 damit entweder nahezu rote Sekundärstrahlung 5 oder blaue Sekundärstrahlung 5 ab. Durch die Änderung der relativen Anordnung von strahlungsemittierenden Bauelement 1 und Träger 2 entlang der Translationsrichtung 90 wie in Figur 1B gezeigt, weist die Sekundärstrahlung 5 eine Mischung der im zweiten Teilbereich 22 reflektierten blauen und der im ersten Teilbereich durch Konversion erzeugten roten elektromagnetischen Strahlung auf. Damit ist die strahlungsemittierende Vorrichtung 100 in der hier beschriebenen Ausgestaltung geeignet, zwischen einem roten und einem blauen Leuchteindruck veränderbare Sekundärstrahlung 5 abzustrahlen. Die möglichen Farborte der durch eine solche Ausgestaltung möglichen abgestrahlte Sekundärstrahlung 5 sind in Figur 7 in einem dem Fachmann bekannten CIE-Diagramm durch die Linie 61 angedeutet. Dabei repräsentieren die beiden Endpunkte der Linie 61 die begrenzenden Farborte der in den Ausrichtungen der Figuren 1A beziehungsweise 1C jeweils abgestrahlten Sekundärstrahlung 5.

Durch entsprechende Wahl des Farborts der Primärstrahlung 4 des strahlungsemittierenden Bauelements 1 sowie durch die Wahl des Wellenlängenkonversionsstoff 31 und der optischen Eigenschaften des Trägers 2 im ersten und zweiten Teilbereich 21, 22 können auch andere Farbortbereiche für die Sekundärstrahlung 5 einstellbar sein, wie beispielhaft durch die Linien 62, 63 und 64 im CIE-Diagramm in Figur 7 angedeutet. Insbesondere kann beispielsweise auch der zweite Teilbereich 22 einen zweiten Wellenlängenkonversionsstoff 32 aufweisen, der vom ersten Wellenlängenkonversionsstoff 31 verschieden ist und durch den der Farbort der Sekundärstrahlung 5 in der in Figur 1C gezeigten relativen Ausrichtung einstellbar ist.

Alternativ zu der vorhergehend beschriebenen Ausgestaltung des Ausführungsbeispiels der Figuren 1A bis 1C kann der Träger 2 im zweiten Teilbereich 22 beispielsweise auch eine absorbierende Oberfläche aufweisen, so dass vom zweiten Teilbereich 22 keine elektromagnetische Strahlung abgestrahlt werden kann. Der Wellenlängenkonversionsstoff 31 im ersten Teilbereich 21 kann weiterhin beispielsweise so gewählt sein, dass die vom Träger 2 abgestrahlte Sekundärstrahlung in der relativen Ausrichtung gemäß Figur 1A den mit E im CIE-Diagramm der Figur 7 bezeichneten Weißpunkt aufweist, wobei alternativ dazu jeder andere Farbort im CIE-Diagramm möglich sein kann. Durch die Änderung der relativen Ausrichtung von strahlungsemittierendem Bauelement 1 und Träger 2 kann somit die Helligkeit der abgestrahlten weißfarbigen Sekundärstrahlung 5 variierbar sein.

Im ersten Teilbereich 21 und/oder im zweiten Teilbereich 22 können zusätzlich auch Streupartikel, etwa eingebettet in ein Matrixmaterial und wie im allgemeinen Teil beschrieben, angeordnet sein, um eine isotrope und gleichmäßige Abstrahlung der Sekundärstrahlung 5 zu ermöglichen oder zu unterstützen.

Im Folgenden werden weitere Ausführungsbeispiele beschrieben, die Variationen und Abwandlungen des in den Figuren 1A bis 1C gezeigten Ausführungsbeispiels darstellen. Daher beschränkt sich die nachfolgende Beschreibung auf die jeweiligen Unterschiede zur strahlungsemittierenden Vorrichtung 100.

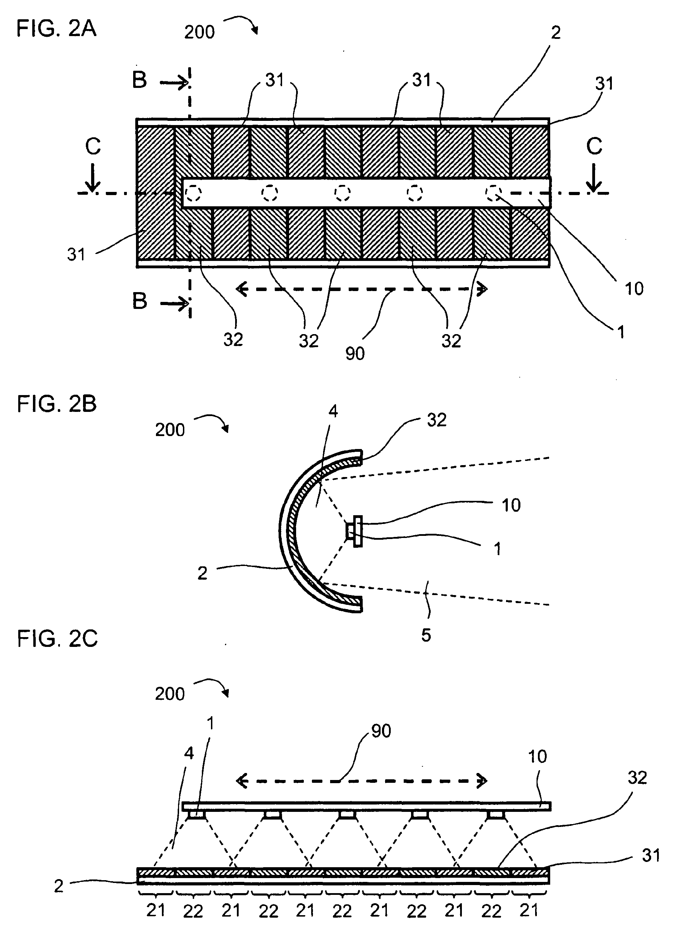

In den Figuren 2A bis 2C ist ein weiteres Ausführungsbeispiel für eine strahlungsemittierende Vorrichtung 200 gezeigt. Die schematischen Darstellungen der Figuren 2B und 2C entsprechen dabei Schnittdarstellungen entlang der Schnittebenen BB beziehungsweise CC in Figur 2A. Die nachfolgende Beschreibung bezieht sich gleichermaßen auf alle Figuren 2A bis 2C.

Die strahlungsemittierende Vorrichtung 200 weist einen Träger 2 mit einer Mehrzahl von ersten und zweiten Teilbereichen 21 und 22 auf, die abwechselnd nebeneinander und aneinander angrenzend angeordnet sind. Der Träger 2 ist dabei ähnlich einem Rinnenreflektor als Teil eines Hohlzylinders mit kreisförmiger Grundlinie ausgebildet, wobei die ersten und zweiten Wellenlängenkonversionsstoffe 31 und 32 auf der Innenseite des Hohlzylinderteils aufgebracht sind. Alternativ oder zusätzlich kann zumindest ein Teil des Trägers 2 als Teil eines Hohlzylinders mit parabolischer oder elliptischer Grundlinie ausgebildet sein. Durch die Hohlzylinderform des Trägers 2 kann beispielsweise eine gerichtete Abstrahlung der Sekundärstrahlung 5 ermöglicht werden. Die Teilbereiche 21 und 22 sind dabei entlang einer Anordnungsrichtung angeordnet, die parallel zur Zylinderachse des den Träger 2 in seiner Form definierenden und zugrunde liegenden Hohlzylinders ist.

Die Teilbereiche 21 weisen einen ersten Wellenlängenkonversionsstoff 31, der ultraviolette bis blaue Primärstrahlung 4 in elektromagnetische Strahlung umwandeln kann, die einen warmweißen Leuchteindruck bei einem Beobachter erweckt. Die Teilbereiche 22 weisen einen zweiten Wellenlängenkonversionsstoff 32 auf, der ultraviolette bis blaue Primärstrahlung 4 in elektromagnetische Strahlung umwandeln kann, die einen kaltweißen Leuchteindruck bei einem Beobachter erweckt.

Weiterhin weist die strahlungsemittierende Vorrichtung 200 eine Mehrzahl von strahlungsemittierenden Bauelementen 1 auf, die jeweils zumindest teilweise ultraviolette bis blaue elektromagnetische Primärstrahlung 4 auf einen ersten und/oder einen zweiten Teilbereich 21, 22 abstrahlen können. Die strahlungsemittierenden Bauelemente 1 sind dabei als LEDs ausgeführt und auf einer mechanisch verschiebbaren Halterung 10 angeordnet. Die Halterung ist dabei entlang der Translationsrichtung 90, die parallel zur Anordnungsrichtung der ersten und zweiten Teilbereich 21, 22 ist, verschiebbar.

Die als LEDs ausgeführten strahlungsemittierenden Bauelemente 1 weisen dabei eine für LEDs typische und dem Fachmann bekannte Lambertsche Abstrahlcharakteristik auf, bei der die abgestrahlte Primärstrahlung 4 eine Cosinus-artige Intensitätsverteilung aufweist, so dass in Richtung eines Lots auf die LEDs, also in Vorwärtsrichtung, Primärstrahlung mit einer höheren Intensität abgestrahlt wird als unter größeren Abstrahlwinkeln zu diesem Lot. Auf einen direkt in Vorwärtsrichtung angeordneten Teilbereich des Trägers wird somit ein höherer Anteil der Primärstrahlung abgestrahlt als auf lateral dazu benachbarte Bereiche. In der in Figur 2C gezeigten relativen Anordnung von strahlungsemittierenden Bauelementen 1 zum Träger 2 wird somit der größte Anteil der Primärstrahlung 4 als zweiter Anteil auf die zweiten Teilbereich 22 abgestrahlt, so dass die strahlungsemittierende Vorrichtung 200 in dieser Anordnung Sekundärstrahlung mit einem kaltweißen Leuchteindruck abstrahlen kann.

Durch eine Änderung der relativen Ausrichtung der Mehrzahl von strahlungsemittierenden Bauelementen 1 durch Verschiebung der Halterung 10 mit den strahlungsemittierenden Bauelementen 1 relativ zum Träger 2 entlang der Translationsrichtung 90 können der erste und zweite Anteil der Primärstrahlung 4 (nicht gezeigt) einander entgegengesetzt verändert werden, so dass der Leuchteindruck der abgestrahlten Sekundärstrahlung zu einem warmweißen Leuchteindruck hin verändert werden kann.

Im CIE-Diagramm der Figur 7 ist ein beispielhafter Farbortbereich, der für die Sekundärstrahlung der strahlungsemittierenden Vorrichtung 200 einstellbar sein kann, durch die Linie 60 angedeutet. Die Linie 60 verläuft dabei entlang eines Teils der Weißlichtlinie 6 des CIE-Diagramms.

Alternativ dazu können auch andere Farbortbereiche für die Sekundärstrahlung der strahlungsemittierenden Vorrichtung 200 durch eine geeignete Wahl der Primärstrahlung sowie der Wellenlängenkonversionsstoffe 31 und 32 erreicht werden.

Die strahlungsemittierende Vorrichtung 200 kann beispielsweise als Schreibtischleuchte oder Deckeleuchte ausgeführt sein oder in derartige Leuchten integriert sein.

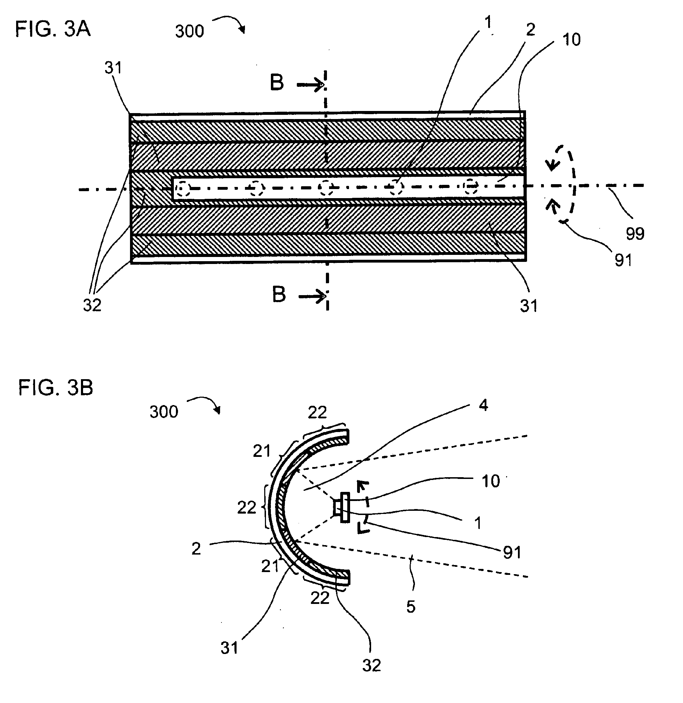

In den Figuren 3A und 3B ist eine weiteres Ausführungsbeispiel für eine strahlungsemittierende Vorrichtung 300 gezeigt, die im Unterschied zum vorherigen Ausführungsbeispiel eine radiale Anordnung der ersten und zweiten Teilbereich 21, 22 in einem einem Rinnenreflektor ähnlichen Gehäuse aufweist. Die Anordnungsrichtung der ersten und zweiten Teilbereich 21, 22 entspricht somit einer gekrümmten Linie entlang des gekrümmten Trägers 2.

Die Mehrzahl von strahlungsemittierenden Bauelementen 1 auf der Halterung 10 sind dabei um eine Achse 99 drehbar, wie durch den Pfeil 91 angedeutet, wobei die Achse 99 senkrecht zur Anordnungsrichtung der ersten und zweiten Teilbereiche 21, 22 ist.

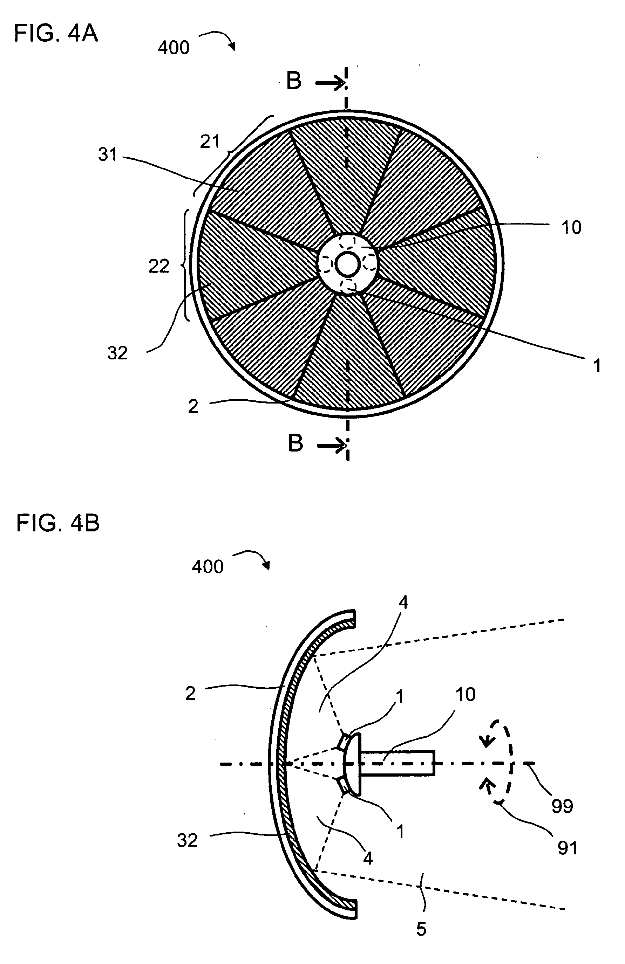

In den Figuren 4A und 4B ist ein weiteres Ausführungsbeispiel für eine strahlungsemittierende Vorrichtung 400 gezeigt, bei der der Träger 2 als rotationssymmetrischer Hohlspiegel in Form eines Teils eines Rotationsellipsoids ausgeführt ist. Die gezeigte Form des Trägers ist jedoch nicht beschränkend zu verstehen. Beispielsweise kann der Träger 2 zumindest teilweise auch als Rotationsparaboloid ausgeführt sein.

Eine Mehrzahl von ersten und zweiten Teilbereichen 21, 22 ist radial um die Rotationsachse 99 des Trägers in Form von gekrümmten Kreissektoren angeordnet. Eine Mehrzahl von strahlungsemittierenden Bauelementen 1 ist ebenfalls radial um die Rotationsachse 99 des Trägers angeordnet. Durch Drehung der Halterung 10 mit den strahlungsemittierenden Bauelementen 1 um die Rotationsachse 99 oder alternativ oder zusätzlich durch Drehung des Trägers 2 um die Achse 99, wie durch den Pfeil 91 angedeutet, kann wieder wie in den vorherigen Ausführungsbeispielen eine Änderung des Farborts der abgestrahlten Sekundärstrahlung erreicht werden.

Bei den Ausführungsbeispielen gemäß der Figuren 2A bis 2C, 3A bis 3B und 4A bis 4B können strahlungsemittierende Vorrichtungen 200, 300 beziehungsweise 400 ermöglicht werden, bei denen der Farbort der Sekundärstrahlung jeweils nur durch eine mechanische Änderung der relativen Anordnung der strahlungsemittierenden Bauelemente 1 zum Träger 2 ermöglicht wird, ohne dass die Betriebsparameter der strahlungsemittierenden Bauelemente 1 geändert werden müssen.

Zusätzlich kann jedoch bei den gezeigten strahlungsemittierenden Vorrichtungen 200, 300 und 400 eine Helligkeitsregelung der abgestrahlten Sekundärstrahlung durch eine Änderung der Betriebsparameter der strahlungsemittierenden Bauelemente 1 ermöglicht werden, wobei die Helligkeitsregelung dann unabhängig von der Einstellung des Farborts möglich ist.

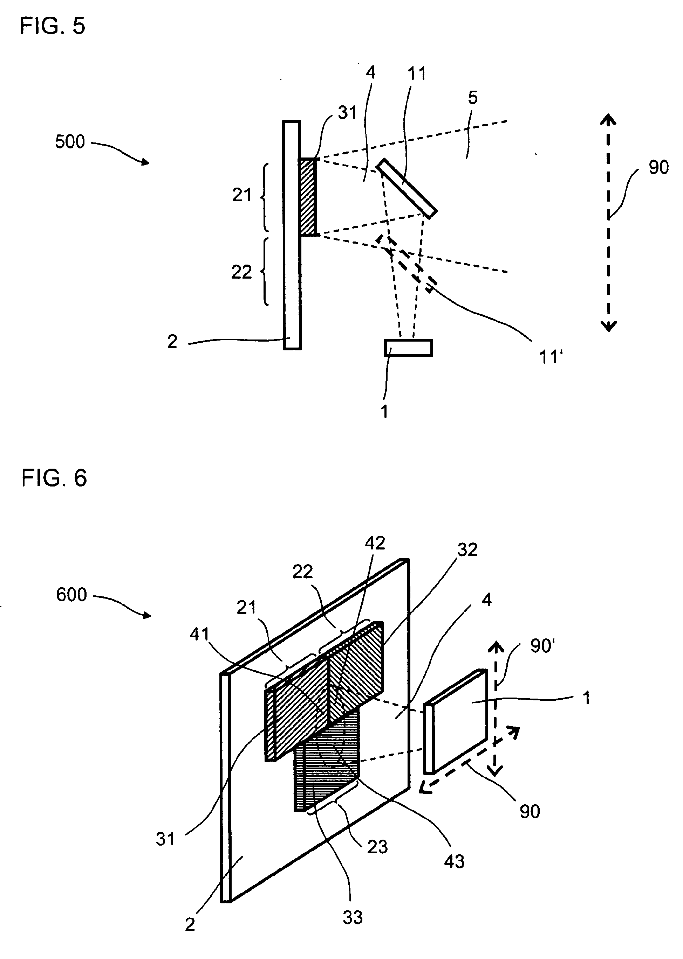

In Figur 5 ist ein weiteres Ausführungsbeispiel für eine strahlungsemittierende Vorrichtung 500 gezeigt, die in ihrer Funktionsweise dem im Zusammenhang mit den Figuren 1A bis 1C gezeigten Ausführungsbeispiel für die strahlungsemittierende Vorrichtung 100 entspricht. Das strahlungsemittierende Bauelement 1 ist in diesem Ausführungsbeispiel jedoch nicht als ganzes relativ zum Träger verschiebbar, sondern weist zusätzlich ein strahlungslenkendes Bauelement 11 auf, das geeignet ist, die elektromagnetische Primärstrahlung 4 auf den Träger 2 und den ersten beziehungsweise zweiten Teilbereich 21, 22 zu lenken. Die in Figur 5 gezeigte relative Ausrichtung entspricht dabei dem in Figur 1A gezeigten Grenzfall. Durch Verschiebung des strahlungslenkenden Bauelements 11 entlang der Translationsrichtung 90 in die durch die gestrichelte Linie angedeutete Position 11' ist der in Figur 1C gezeigte Grenzfall einstellbar. Das strahlungslenkende Bauelement 11 ist dabei im gezeigten Ausführungsbeispiel ein Spiegel. Alternativ oder zusätzlich zu der gezeigten Verschiebbarkeit des strahlungslenkenden Bauelements 11 entlang der Translationsrichtung 90 ist auch eine Rotation möglich (nicht gezeigt).

In Figur 6 ist ein weiteres Ausführungsbeispiel für eine strahlungsemittierende Vorrichtung 600 gezeigt, bei der der Träger 2 zusätzlich zum ersten Teilbereich 21 mit einem ersten Wellenlängenkonversionsstoff 31 und zum zweiten Teilbereich 22 mit einem zweiten Wellenlängenkonversionsstoff 32 einen dritten Teilbereich 23 mit einem dritten Wellenlängenkonversionsstoff 33 aufweist. Die drei Teilbereich 21, 22 und 23 sind dabei jeweils zueinander benachbart und direkt aneinander angrenzend angeordnet.

Die in Figur 6 gezeigte strahlungsemittierende Vorrichtung 600 ermöglicht eine um einen weiteren Freiheitsgrad erweiterte Variabilität der abgestrahlten Sekundärstrahlung (aus Gründen der Übersichtlichkeit nicht gezeigt). Durch eine Verschiebung entlang der zwei zueinander nicht-parallelen Translationsrichtungen 90 und 90', die den Anordnungsrichtungen der drei Teilbereiche 21, 22 und 23 zueinander entsprechen, können die auf die Teilbereiche 21, 22 und 23 jeweils abgestrahlte erste, zweite und dritte Anteil 41, 42 und 43 eingestellt werden. Dadurch ist in dem gezeigten Ausführungsbeispiel eine Einstellbarkeit des Farborts der Sekundärstrahlung zwischen drei Grenzfarborten möglich, wie beispielhaft in Figur 7 durch das Farbortdreieck 65 gezeigt. Die Eckpunkte des Farbortdreiecks sind dabei durch die Auswahl des strahlungsemittierenden Bauelements 1 und der von diesem abgestrahlten Primärstrahlung 4 sowie durch die Wahl der Wellenlängenkonversionsstoffe 31, 32 und 33 gegeben. Weiterhin können die Eckpunkte des Farbortdreiecks durch die jeweiligen Reflexions-, Streu- und/oder Absorptionseigenschaften des Trägers 2 und dessen Oberfläche in den Teilbereichen 21, 22 und 23 beeinflusst werden.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Konkrete geeignete Leuchtstoffe und Leuchtstoffkombinationen finden sich in zahlreichen Publikationen, beispielsweise in US 20060113553, US 7026755, EP 1630220, oder WO 2006012833. Gut geeignet sind Granate, Nitride und Nitridosilikate.

## Patentansprüche

1. **Beleuchtungsvorrichtung,** die eine elektromagnetische Sekundärstrahlung (5) emittiert, umfassend
- zumindest ein strahlungsemittierendes Bauelement (1), das im Betrieb elektromagnetische Primärstrahlung, (4) auf einen im Strahlengang des strahlungsemittierenden Bauelements (1) angeordneten Träger (29) mit einem ersten und einem zweiten Teilbereich (21, 22) emittiert und
- einen im ersten Teilbereich (21) angeordneten ersten Wellenlängenkonversionsstoff (31) zur zumindest teilweisen Konversion der Primärstrahlung (4),
wobei
- der erste und zweite Teilbereich (21, 22) voneinander verschieden sind,
- die von der strahlungsemittierenden Vorrichtung abgestrahlte Sekundärstrahlung (5) die von dem ersten und/oder zweiten Teilbereich (21, 22) abgestrahlte elektromagnetische Strahlung umfasst und
- die Sekundärstrahlung (5) durch eine Änderung der Ausrichtung des strahlungsemittierenden Bauelements (1) relativ zum Träger (2) veränderbar ist und **dadurch gekennzeichnet, dass**
- **die vom ersten Teilbereich (21) abgestrahlte elektromagnetische Strahlung bei einem externen Beobachter einen warmweißen Leuchteindruck erweckt und**
- **die vom zweiten Teilbereich (22) abgestrahlte elektromagnetische Strahlung bei einem externen Beobachter einen kaltweißen Leuchteindruck erweckt,**
so dass
- **die Sekundärstrahlung durch die Änderung der Ausrichtung des strahlungsemittierenden Bauelements relativ zum Träger zwischen einem warmweißen und einem kaltweißen Leuchteindruck veränderbar ist.**

2. **Beleuchtungsvorrichtung** nach dem vorherigen Anspruch, wobei
- das strahlungsemittierende Bauelement (1) so relativ zum Träger angeordnet ist, dass es einen ersten Anteil (41) der Primärstrahlung (4) auf den ersten Teilbereich (21) und einen zweiten Anteil (42) der Primärstrahlung (4) auf den zweiten Teilbereich (22) stahlt und
- zumindest einer des ersten Anteils (41) und des zweiten Anteils (42) der Primärstrahlung (4) durch die Änderung der Ausrichtung des strahlungsemittierenden Bauelements (1) relativ zum Träger (2) veränderbar ist.

3. **Beleuchtungsvorrichtung** nach dem vorherigen Anspruch, wobei
- der erste Anteil (41) und der zweite Anteil (42) entgegengesetzt zueinander veränderbar sind.

4. **Beleuchtungsvorrichtung** nach dem vorherigen Anspruch, wobei
- die Sekundärstrahlung (5) durch eine Translation (90) des strahlungsemittierenden Bauelements (1) relativ zum Träger (2) änderbar ist.

5. **Beleuchtungsvorrichtung** nach dem vorherigen Anspruch, wobei
- der erste und der zweite Teilbereich (41, 42) entlang einer Anordnungsrichtung auf dem Träger angeordnet sind und
- das strahlungsemittierende Bauelement (1) entlang dieser Anordnungsrichtung relativ zum Träger (2) verschiebbar ist.

6. **Beleuchtungsvorrichtung** nach einem der vorherigen Ansprüche, wobei
- die Sekundärstrahlung (5) durch eine Rotation (91) des strahlungsemittierenden Bauelements (1) relativ zum Träger (2) änderbar ist.

7. **Beleuchtungsvorrichtung** nach dem vorherigen Anspruch, wobei
- der erste und der zweite Teilbereich (41, 42) entlang einer Anordnungsrichtung auf dem Träger angeordnet sind und
- das strahlungsemittierende Bauelement (1) relativ zum Träger (2) um eine Achse (99) senkrecht zu dieser Anordnungsrichtung drehbar ist.

8. **Beleuchtungsvorrichtung** nach einem der vorherigen Ansprüche, wobei
- das strahlungsemittierende Bauelement (1) weiterhin ein strahlungslenkendes Bauelement (11) im Strahlengang der Primärstrahlung (4) aufweist und
- die von der strahlungsemittierenden Vorrichtung abgestrahlte Sekundärstrahlung (5) durch ein Verschieben (90) und/oder durch eine Drehung (91) des strahlungslenkenden Bauelements (11) relativ zum Träger (2) änderbar ist.

9. **Beleuchtungsvorrichtung** nach dem vorherigen Anspruch, wobei
- das strahlungslenkende Bauelement (11) einen Spiegel, ein Prisma, einen Lichtleiter, eine Linse oder eine Kombination daraus umfasst.

10. **Beleuchtungsvorrichtung** nach einem der vorherigen Ansprüche, wobei
- der erste und der zweite Teilbereich (21, 22) auf dem Träger direkt aneinander angrenzen.

11. **Beleuchtungsvorrichtung** nach einem der vorherigen Ansprüche, wobei
- der Träger (2) eine gekrümmte Form aufweist.

12. **Beleuchtungsvorrichtung** nach einem der vorherigen Ansprüche, wobei
- eine Mehrzahl von strahlungsemittierenden Bauelementen (1) vorhanden ist,
- eine Mehrzahl von ersten und zweiten Teilbereichen (21, 22) vorhanden ist und
- jeweils zumindest ein erster und eine zweiter Teilbereich (21, 22) im Strahlengang eines strahlungsemittierenden Bauelements (1) angeordnet sind.

13. **Beleuchtungsvorrichtung** nach einem der vorherigen Ansprüche, wobei
- der zweite Teilbereich (22) einen zweiten Wellenlängenkonversionsstoff (32) aufweist, der verschieden vom ersten Wellenlängehkonversionsstoff (31) ist.

14. **Beleuchtungsvorrichtung** nach einem der vorherigen Ansprüche, wobei
- der Träger (2) im ersten Teilbereich (21) und/oder im zweiten Teilbereich (22) eine für die Primärstrahlung (4) reflektierende Oberfläche aufweist.

15. **Beleuchtungsvorrichtung** nach einem der vorherigen Ansprüche, wobei
- die reflektierende Oberfläche diffus reflektierend ist.

16. **Beleuchtungsvorrichtung** nach dem vorherigen Anspruch, wobei
- der erste Teilbereich (21) und/oder der zweite Teilbereich (22) Streupartikel aufweist.

17. **Beleuchtungsvorrichtung** nach dem vorherigen Anspruch, wobei
- die Streupartikel ein Metalloxid und/oder Glas umfassen.

18. **Beleuchtungsvorrichtung** nach einem der vorherigen Ansprüche, wobei
- der Träger (2) im ersten Teilbereich (21) und/oder im zweiten Teilbereich (22) eine für die Primärstrahlung (4) absorbierende Oberfläche aufweist.

19. **Beleuchtungsvorrichtung** nach einem der vorherigen Ansprüche, wobei
- der Träger (2) weiterhin zumindest einen dritten Teilbereich (23) aufweist, der vom ersten und zweiten Teilbereich (21, 22) verschieden ist.

20. **Beleuchtungsvorrichtung** nach einem der vorherigen Ansprüche, wobei
- das strahlungsemittierende Bauelement (1) eine Licht emittierende Diode umfasst.

## Claims

1. Illumination device, which emits secondary electromagnetic radiation (5), comprising
- at least one radiation-emitting component (1) which, during operation, emits primary electromagnetic radiation (4) onto a carrier (2) that is arranged in the beam path of the radiation-emitting component (1) and comprises a first and a second subregion (21, 22) and
- a first wavelength conversion material (31), arranged in the first subregion (21), for at least partial conversion of the primary radiation (4),
wherein
- the first and second subregions (21, 22) are different from one another,
- the secondary radiation (5) radiated by the radiation-emitting device comprises the electromagnetic radiation radiated by the first and/or second subregion (21, 22) and
- the secondary radiation (5) can be varied by modifying the alignment of the radiation-emitting component (1) relative to the carrier (2),
**characterized in that**
- the electromagnetic radiation radiated by the first subregion (21) imparts a warm white light impression to an external observer and
- the electromagnetic radiation radiated by the second subregion (22) imparts a cold white light impression to an external observer
so that
- the secondary radiation can be varied between a warm white and a cold white light impression by modifying the alignment of the radiation-emitting component relative to the carrier.

2. Illumination device according to the preceding claim, wherein
- the radiation-emitting component (1) is arranged relative to the carrier in such a way that it radiates a first fraction (41) of the primary radiation (4) onto the first subregion (21) and a second fraction (42) of the primary radiation (4) onto the second subregion (22) and
- at least one of the first fraction (41) and the second fraction (42) of the primary radiation (4) can be varied by modifying the alignment of the radiation-emitting component (1) relative to the carrier (2).

3. Illumination device according to the preceding claim, wherein
- the first fraction (41) and the second fraction (42) can be varied oppositely to one another.

4. Illumination device according to the preceding claim, wherein
- the secondary radiation (5) can be varied by translation (90) of the radiation-emitting component (1) relative to the carrier (2).

5. Illumination device according to the preceding claim, wherein
- the first and second subregions (41, 42) are arranged along an arrangement direction on the carrier and
- the radiation-emitting component (1) can be displaced relative to the carrier (2) along this arrangement direction.

6. Illumination device according to one of the preceding claims, wherein
- the secondary radiation (5) can be varied by rotation (91) of the radiation-emitting component (1) relative to the carrier (2).

7. Illumination device according to the preceding claim, wherein
- the first and second subregions (41, 42) are arranged along an arrangement direction on the carrier and
- the radiation-emitting component (1) can be rotated relative to the carrier (2) about an axis (99) perpendicular to this arrangement direction.

8. Illumination device according to one of the preceding claims, wherein
- the radiation-emitting component (1) furthermore comprises a radiation-guiding component (11) in the beam path of the primary radiation (4) and
- the secondary radiation (5) radiated by the radiation-emitting device can be varied by displacement (90) and/or rotation (91) of the radiation-guiding component (11) relative to the carrier (2).

9. Illumination device according to the preceding claim, wherein
- the radiation-guiding component (11) comprises a mirror, a prism, a light guide, a lens or a combination thereof.

10. Illumination device according to one of the preceding claims, wherein
- the first and second subregions (21, 22) directly adjoin one another on the carrier.

11. Illumination device according to one of the preceding claims, wherein
- the carrier (2) has a curved shape.

12. Illumination device according to one of the preceding claims, wherein
- a multiplicity of radiation-emitting components (1) are provided,
- a multiplicity of first and second subregions (21, 22) are provided and
- respectively at least one first and one second subregion (21, 22) is arranged in the beam path of a radiation-emitting component (1).

13. Illumination device according to one of the preceding claims, wherein
- the second subregion (22) comprises a second wavelength conversion material (32) which is different from the first wavelength conversion material (31).

14. Illumination device according to one of the preceding claims, wherein
- the carrier (2) has a surface which is reflective for the primary radiation (4) in the first subregion (21) and/or in the second subregion (22).

15. Illumination device according to one of the preceding claims, wherein
- the reflective surface is diffusely reflective.

16. Illumination device according to the preceding claim, wherein
- the first subregion (21) and/or the second subregion (22) comprises scattering particles.

17. Illumination device according to the preceding claim, wherein
- the scattering particles comprise a metal oxide and/or glass.

18. Illumination device according to one of the preceding claims, wherein
- the carrier (2) has a surface which is absorbent for the primary radiation (4) in the first subregion (21) and/or in the second subregion (22).

19. Illumination device according to one of the preceding claims, wherein
- the carrier (2) furthermore comprises at least one third subregion (23), which is different from the first and second subregions (21, 22).

20. Illumination device according to one of the preceding claims, wherein
- the radiation-emitting component (1) comprises a light-emitting diode.

## Revendications

1. Dispositif d'éclairage émettant un rayonnement électromagnétique secondaire (5), comprenant
- au moins un composant émetteur de rayonnement (1), qui émet en fonctionnement un rayonnement électromagnétique primaire (4) sur un support (29) disposé dans la trajectoire des rayons du composant émetteur de rayonnement (1) et comportant une première et une deuxième portion (21, 22), et
- un premier matériau de conversion de longueur d'onde (31) disposé dans la première portion (21) pour la conversion au moins partielle du rayonnement primaire (4),
- la première et la deuxième portion (21, 22) étant différentes l'une de l'autre,
- le rayonnement secondaire (5) émis par ledit dispositif émetteur de rayonnement comprenant le rayonnement électromagnétique émis par la première et/ou la deuxième portion (21, 22) et
- le rayonnement secondaire (5) pouvant être modifié par un changement de l'orientation du composant émetteur de rayonnement (1) par rapport au support (2),
**caractérisé en ce que**
- le rayonnement électromagnétique émis par la première portion (21) suscite chez l'observateur externe une impression d'éclairage blanc chaud et
- le rayonnement électromagnétique émis par la deuxième portion (22) suscite chez l'observateur externe une impression d'éclairage blanc froid,
de telle sorte que
- le rayonnement secondaire peut être modifié par le changement de l'orientation du composant émetteur de rayonnement par rapport au support, entre une impression d'éclairage blanc chaud et une impression d'éclairage blanc froid.

2. Dispositif d'éclairage selon la revendication précédente,
- le composant émetteur de rayonnement (1) étant disposé par rapport au support de façon à émettre une première fraction (41) du rayonnement primaire (4) sur la première portion (21) et une deuxième fraction (42) du rayonnement primaire (4) sur la deuxième portion (22) et
- au moins l'une de la première fraction (41) et de la deuxième fraction (42) du rayonnement primaire (4) pouvant être modifiée par le changement de l'orientation du composant émetteur de rayonnement (1) par rapport au support (2).

3. Dispositif d'éclairage selon la revendication précédente,
- la première fraction (41) et la deuxième fraction (42) pouvant être modifiées de manière opposée l'une à l'autre.

4. Dispositif d'éclairage selon la revendication précédente,
- le rayonnement secondaire (5) pouvant être modifié par une translation (90) du composant émetteur de rayonnement (1) par rapport au support (2).

5. Dispositif d'éclairage selon la revendication précédente,
- la première et la deuxième portion (41, 42) étant disposées sur le support le long d'une direction de rangement et
- le composant émetteur de rayonnement (1) étant déplaçable par rapport au support (2) le long de cette direction de rangement.

6. Dispositif d'éclairage selon l'une des revendications précédentes,
- le rayonnement secondaire (5) pouvant être modifié par une rotation (91) du composant émetteur de rayonnement (1) par rapport au support (2).

7. Dispositif d'éclairage selon la revendication précédente,
- la première et la deuxième portion (41, 42) étant disposées sur le support le long d'une direction de rangement et
- le composant émetteur de rayonnement (1) étant mobile par rapport au support (2) autour d'un axe (99) perpendiculaire à cette direction de rangement.

8. Dispositif d'éclairage selon l'une des revendications précédentes,
- le composant émetteur de rayonnement (1) comportant en outre un composant de guidage de rayonnement (11) dans la trajectoire des rayons du rayonnement primaire (4) et
- le rayonnement secondaire (5) émis par ledit dispositif émetteur de rayonnement pouvant être modifié par un déplacement (90) et/ou par une rotation (91) du composant de guidage de rayonnement (11) par rapport au support (2).

9. Dispositif d'éclairage selon la revendication précédente,
- le composant de guidage de rayonnement (11) comprenant un miroir, un prisme, un guide de lumière, une lentille ou une combinaison de ceux-ci.

10. Dispositif d'éclairage selon l'une des revendications précédentes,
- la première et la deuxième portion (21, 22) étant directement contigües sur le support.

11. Dispositif d'éclairage selon l'une des revendications précédentes,
- le support (2) ayant une forme courbe.

12. Dispositif d'éclairage selon l'une des revendications précédentes,
- une pluralité de composants émetteurs de rayonnement (1) étant prévue,
- une pluralité de premières et deuxièmes portions (21, 22) étant prévue et
- au moins une première et une deuxième portion (21, 22) étant disposées dans la trajectoire des rayons d'un composant émetteur de rayonnement (1).

13. Dispositif d'éclairage selon l'une des revendications précédentes,
- la deuxième portion (22) comportant un deuxième matériau de conversion de longueur d'onde (32), différent du premier matériau de conversion de longueur d'onde (31).

14. Dispositif d'éclairage selon l'une des revendications précédentes,
- le support (2) comportant dans la première portion (21) et/ou dans la deuxième portion (22) une surface réfléchissante pour le rayonnement primaire (4).

15. Dispositif d'éclairage selon l'une des revendications précédentes,
- la surface réfléchissante étant à réflexion diffuse.

16. Dispositif d'éclairage selon la revendication précédente,
- la première portion (21) et/ou la deuxième portion (22) comportant des particules de dispersion.

17. Dispositif d'éclairage selon la revendication précédente,
- les particules de dispersion contenant un oxyde métallique et/ou du verre.

18. Dispositif d'éclairage selon l'une des revendications précédentes,
- le support (2) comportant dans la première portion (21) et/ou dans la deuxième portion (22) une surface absorbante pour le rayonnement primaire (4).

19. Dispositif d'éclairage selon l'une des revendications précédentes,
- le support (2) comportant en outre au moins une troisième portion (23), différente de la première et la deuxième portion (21, 22).

20. Dispositif d'éclairage selon l'une des revendications précédentes,
- le composant émetteur de rayonnement (1) comprenant une diode électroluminescente.
